# EUROPEAN PATENT APPLICATION

(11) **EP 2 267 534 A1**
(43) Date of publication of application: **29.12.2010**
(21) Application number: 09163416.2
(22) Date of filing: 22.06.2009
(51) Int. Cl.: G03F 7/20

(54) **Illumination system**

(71) Applicant: Nederlandse Organisatie voor Toegepast -Natuurwetenschappelijk Onderzoek TNO, 2628 VK Delft (NL)
(72) Inventor: Jamar, Jacobus Hubertus Theodoor, 5512 BN Vessem (NL)
(74) Representative: Hatzmann, Martin

(57) **Abstract**

A method for patterning a substrate (5), the method comprising: illuminating a predetermined area of the substrate by means of an illumination system (20) that comprises an array of light sources (21) controllable to form time-varying images, an image projection system (22), and a microlens array (7) comprising individual microlenses (8) which are arranged to provide an optical light path for the light sources, the image projection system being arranged for projecting the images onto the microlens array such that individual ones of the microlenses (8) each project radiation (18) incident thereon in the form of separate corresponding concentrated microspots (17) onto said predetermined area; wherein the array of light sources (21) is statically arranged along an arc segment having a radius and the microlenses (8) are circumferentially arranged on the microlens array on a perimeter corresponding to the arc segment, and wherein the microlens array (7) is controlled to perform a rotating movement (9) which is parallel to a straight plane, relative to at least part of the image projection system (22) and relative to the substrate (5), while synchronously the array of light sources (21) is controlled to form the time-varying images, in such way that during said rotating movement (9) of the microlens array (7) the microspots (17) describe an arc pattern on the predetermined area of the substrate (5).

## Description

In the art, large area projection for patterning surfaces, for instance, large area panel displays, large area flexible foils or the like, involves complex lithographic systems, which are typically aligned to cover at least a breadth dimension of an area to be irradiated. Large area projection systems may involve Digital Micromirror Devices (DMD). However, the working area of such systems is relatively small. When it is desired to produce larger substrates, larger working areas are required, for example in the order of magnitude 30 cm x 40 cm or even 1x3 m, for example, for producing large area panel displays or smart foil systems, wherein a foil or any suitable substrate is patterned with specific circuitry to produce complex (opto)electronic devices. When, in addition, it is desired to produce such larger substrates with the same accuracy as the smaller substrates, correspondingly higher pixel amounts would be required. However, employing such high pixel amounts is currently not within reach. Thus, it is desired to accurately produce small product details for larger substrates.

### SUMMARY OF THE INVENTION

It is an object of the invention to provide a solution according to which, for illumination of larger sized products, larger working areas of layers can be patterned with high resolution and without needing to increase the resolution of an array of light sources of an illumination system used in the production.

Therefore, according to a first aspect of the invention, a method according to claim 1 is provided.

In this method according to the first aspect of the invention, a method for patterning a substrate is provided, the method comprising illuminating a predetermined area by means of an illumination system that comprises an array of light sources, controllable to form time-varying images, an image projection system and a microlens array comprising microlenses which are arranged to provide an optical light path for the light sources, the image projection system being arranged for projecting the images onto the microlens array such that individual ones of the microlenses each project radiation incident thereon in the form of separate corresponding concentrated microspots onto the predetermined area of the substrate;
wherein the array of light sources is statically arranged along an arc segment having a radius and the microlenses are circumferentially arranged on the microlens array on a perimeter corresponding to the arc segment, the microlens array being controlled to perform a rotating movement which is parallel to a straight plane, relative to at least part of the image projection system and relative to the substrate, while synchronously the array of light sources is controlled to form the time-varying images, in such way that during said rotating movement of the microlens array the microspots describe a one dimensional arc pattern on a predetermined area of the substrate; and wherein the substrate is moved in a direction substantially transverse to the arc segment.

In this way, the microspots "write" over the substrate in order to pattern the predetermined area of it. In order to obtain high resolution, the separate concentrated microspots may be arranged at relatively large distances apart from each other, since the intermediate spaces between the microspots can be reached in the course of time during the "writing".

A method according to claim 1 has the advantage that it requires only little mass (i.e. substantially only the mass of the microlens array) to be moved with high accuracy. In addition, the rotating movement can be performed smoothly, well controlled and continuously. This is less complicated to realize and less energy consuming than moving the larger mass of for example a total illumination system, or than moving an substrate under construction.

Furthermore, according to a second aspect of the invention, an illumination system according to claim 6 is provided.

Specific embodiments of the invention are set forth in the dependent claims.

These and other aspects of the invention will be apparent from and elucidated with reference to the embodiments described hereinafter.

### BRIEF DESCRIPTION OF THE DRAWINGS

Further details, aspects and embodiments of the invention will be described, by way of example only, with reference to the schematic figures in the enclosed drawing.
Fig. 1 schematically shows, in schematic perspective side view, an example of an embodiment of an illumination system according to the invention used in a system for use in an example of an embodiment of a method according to the invention.
Fig. 2 schematically shows, in plan view, a portion of a setup of the light source array of the illumination system of Fig. 1.
Fig. 3 schematically shows, in plan view, a corresponding portion of the microlens array of Fig. 2.
Fig. 4 schematically shows, in sectional view, the microlens action for the array of light sources arranged along plural circumferences.

### DETAILED DESCRIPTION

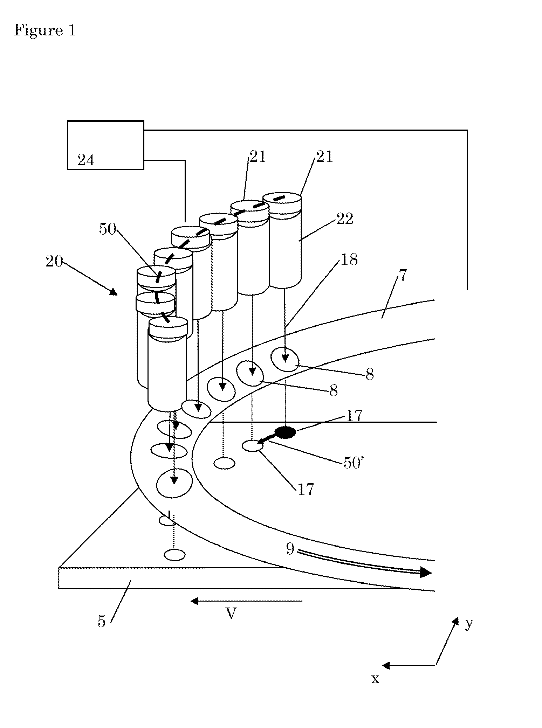

Reference is first made to Fig. 1 which shows an example of a system 1 for patterning a substrate 5. The system 1 can perform an example of a method for patterning a substrate according to the invention. The substrate 5 is shown while being moved. It may be a rigid substrate for manufacturing for example silicon based circuitry; or it may be flexible, for example for manufacturing organic circuitry typically comprising a number of opto/electronic structures.

The system 1 further comprises an illumination system 20. The illumination system 20 is arranged for illuminating a predetermined area of a substrate 5 in order to provide a predefined illumination pattern to the substrate 5 which may be used for example to provide a detail of an optoelectronic structure in the substrate 5. Detail of the illumination and its purpose is deemed within the reach of the skilled person and will not be further elaborated.

The illumination system 20 comprises an array of light sources 21, an image projection system 22, and a microlens array 7. The array of light sources 21 is controllable to form time-varying images. Microlens array 7 comprises individual microlenses 8 which are arranged in two dimensions of a straight plane. The image projection system 22 is arranged for projecting the images onto the microlens array 7 such that individual ones of the microlenses 8 each project radiation 18 incident thereon in the form of separate corresponding concentrated microspots 17 onto the predetermined area of the substrate 5. The array of light sources, the image projection system and the microlens array may each as such be of various types, such as the various types known in the art of illuminations systems. For example, the array of light sources may be aligned laser diodes 21 which may be optically coupled to optics 20 to project the diodes in a collimated bundle 18. Alternatively, the array of light sources 21 may be a plurality of LEDs 21, which may be directly or via fibers 20 directed to microlens array 7. Additionally, individual light bundles 18 may be provided by a DMD device, which may be specially adapted to conform to an arc layout as further elaborated here below.

As a special technical feature of the invention, the microlens array 7 is controllable to perform a rotating movement which is parallel to a straight plane, as well as relative to at least part of the image projection system 22. Such a movement of the microlens array 7 is indicated by double-arrow 9 in Fig. 1.

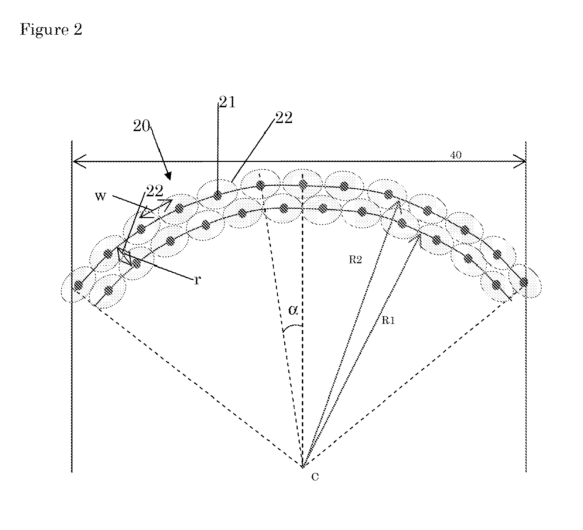

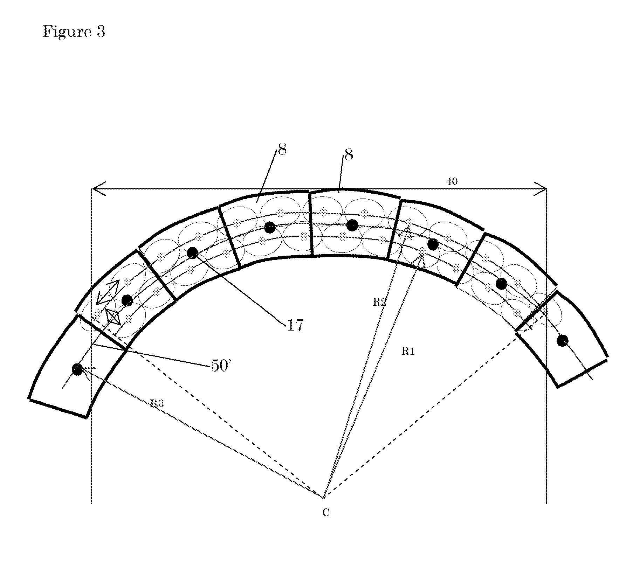

As a further aspect of the invention, the illumination system 20 further comprises a controller 24 for controlling the microlens array 7 to perform said movement 9 and for controlling the array of light sources 21 to form the time-varying images synchronously with said movement 9 in such way that during said rotating movement 9 of the microlens array 7 the microspots 17 describe an arc pattern 50' on a predetermined area of the substrate 5 when, during patterning of the substrate, said movement 9 is also relative to the substrate 5. Furthermore, as can be seen in Figure 1 and further detailed in Figure 2, the array of light sources 21 is arranged along an arc segment 50. As further detailed in Figure 3, the microlenses 8 are circumferentially arranged on the microlens array along a perimeter corresponding to the arc segment 50. To provide patterning of a two-dimensional area of the substrate 5, the substrate is moved in a direction V substantially transverse to the arc segment 50.

Although variations are feasible wherein plural scan lines are illuminated simultaneously; typically, the projected arc segment is one-dimensional and the substrate movement has a constant velocity. Thus, the arc-segment extends only in a tangential direction and has limited extension in a radial direction. Typically, the substrate 5 is moved via a substrate holder that is actuated relative to a stationary substrate table (not shown).

As follows from the above, the described system in Fig. 1 that comprises the described illumination system 20 can be used in a method according to claim 1.

Reference is now made to Figs. 2 and 3.

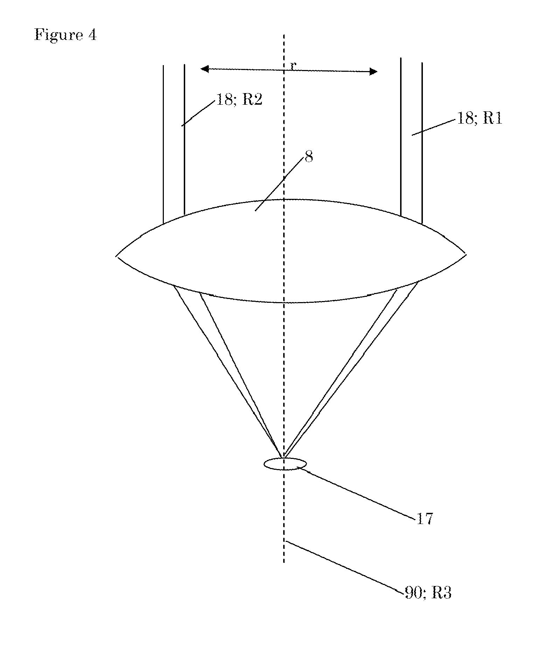

As shown in Figure 2, preferably, the method is carried out with the array of light sources 21 arranged along plural circumferences having respective radiuses R1, R2 and having a common centre C. In such case, more light can be transmitted through the microlenses 8 (see Fig 4). Reference numeral 40 indicates a working area of the substrate 5 (see Fig. 1). A typical dimension may be 300 mm. The predetermined area of the substrate 5 that has to be patterned is comprised in a working area 40 covering a breadth dimension of substrate 5. In the embodiment, the light sources 21 are provided by laser diodes. Because of the diode's radiation pattern, projection lenses 22 may have an elliptical aperture for example, of 1.5 x 1.0 mm. accordingly a radial distance r between inner and outer radius may be about 1 mm. A tangential distance w between two light sources 21 on a circumference may be about 1.5 mm. The aperture of lens 22 may be sufficient to capture a diode's output within the FWHM. As schematically depicted, the light sources of subsequent circumferences may be positioned with a relative angle shift of radiuses connecting a respective microlens and the common centre c. Depending on geometry, a typical angle shift can be about 0.5°. Typically, the array is stationary fixed relative to the outside world.

Fig. 3 shows, in plan view, a portion of the microlens array 7 of Fig. 1 at an instantaneous point in time during illumination. Note that the full array is substantially covering a full circular perimeter. The shown portion comprises microlenses 8 aligned in a rectangular arc shape along a circular perimeter. Each microlens 8 preferably has an optical axis arranging along the arc-perimeter 50 (corresponding to radius R3) and with projected pixels 17 of the time-varying images formed by the array of light sources 21. In Fig. 3 it is shown that the microlens 8 projects the radiation 18 incident thereon in the form of a corresponding concentrated microspot 17 onto the predetermined area of the substrate 5. In plan view, the concentrated microspot 17 will be substantially centered relative to its corresponding microlens 8.

As stated, during a method cycle, the microlens array 7 can be controlled to perform said rotating movement 9, while synchronously the array of light sources 21 is controlled to form the time-varying images, in such way that during said movement 9 the microspots 17 describe an arc pattern 50' at the predetermined area of the substrate 5. During such movement 9, the part of the trajectory of the emitted radiation 18 before the radiation reaches the microlens array remains, in the shown example, fixed relative to the outside world and relative to a direction perpendicular to the substrate movement direction V - in the figure denoted as y-direction. This means that the microspots 17 will move relative to the substrate 5 in arc form since the microspots 17 will remain substantially centered relative to their corresponding microlenses 8.

In order to avoid cross-talk between neighboring microlenses 8, said controlling may include to time-dependently stop projecting radiation 18 for those pixels for which the corresponding radiation would be incident at or close to the transitions between neighboring microlenses 8.

Accordingly, each laser diode is preferably used only when its beam is fully within one of the moving lenses 8. That is typically 50% of the time.

The distance between spots 17 along an arc 50' for one moving lens 8 and for the next moving lens depends on lens rotation speed and substrate velocity; and may typically be about 2 um. By modification of the lens, the spot resolution can be increased by tracing intermediate positions, for example, at 1 um in between, through spots from a diode row of a subsequent circumference. In this case, a single laser diode's spot can make a trace of, for example, 15 mm, or 15000 pixels, for each moving lens that passes.

Note that in Fig 3 all microlens centres are black-filled circles 17. This is only done for illustrative purposes. In fact, whether or not a particular position in the working area must be a microspot 17, is depending upon the predetermined geometry of the substrate 5 to be produced.

Fig. 4 shows an individual microlens 8 of array 7 in sectional view along a radial direction r in the plane of paper. It is shown that the microlenses 8 are dimensioned to span said array in a radial direction so that the microspots are projected on a common arc segment 50' (see Fig. 1). Preferably, but not necessarily, the method is carried out such that the image projection system projects the images onto the microlens array 7 such that radiation corresponding to the images is incident on the microlens array 7 in a direction which is substantially orthogonal to a straight plane. An advantage of such substantially orthogonally incident radiation is, that it ensures that the microspots 17 will be accurately centered relative to their corresponding microlenses 8 on the optical axis 90, thus improving the accuracy of production of substrates 5.

As an illustration of only one of the very many possibilities, the following practical example is given. In this example, the working area has a breadth dimension of 300 millimeter. The array of light sources is based upon a laser diode array of 700 diodes to cover an arc covering this working area. The microlens array has about 350 equidistant lenses typically spaced about 1.5 mm (w in Fig. 2) and arranged on a circular arc having a radius of around 170 mm (R1, R2). Each projection lens 22 has aperture dimensions 1.5 millimeter. The rotating scanning movement of the microlens array 7 may be about 100 Hz, wherein the modulation may be about 105 MHz, resulting in pixels having an arc spacing of about 1 um. With a substrate velocity V of 60mm/s a scan line spacing is about 0.8 um corresponding to about 1200 lines per mm.

It is remarked that advantageous effects of performing the illumination method are obtained when the method is adapted in that, instead of moving the microlens array 7 relative to at least part of the image projection system 20 and relative to outside world, the array of light sources and/or the image projection system are controllably moved together with the microlens array relative to the outside world. Hence, in such adapted method, for example the total illumination system is controllably moved relative to the outside world, for example by moving the total illumination system 20 relative to the outside world while keeping the substrate 5 under construction fixed relative to the to outside world, or by moving the substrate 5 under construction relative to the outside world while keeping the total illumination system 20 fixed relative to the outside world.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

Furthermore, it is remarked that the described illumination system can also be used in other methods for production of substrates, which other methods are adapted relative to the methods described above. One such adaptation is that the method is repeatedly performed for the production of plural layers of the substrate. Another such adaptation is that a foil is applied to a substrate under construction, which foil is then partly illuminated. Such illumination may directly result in illuminated parts of the foil being patterned.

## Claims

1. A method for patterning a substrate (5), the method comprising:
- illuminating a predetermined area by means of an illumination system (20) that comprises an array of light sources (21), controllable to form time-varying images, an image projection system (22) and a microlens array (7) comprising microlenses (8) which are arranged to provide an optical light path for the light sources, the image projection system being arranged for projecting the images onto the microlens array such that individual ones of the microlenses (8) each project radiation (18) incident thereon in the form of separate corresponding concentrated microspots (17) onto the predetermined area of the substrate (5);
- wherein the array of light sources (21) is arranged along an arc segment having a radius and the microlenses (8) are circumferentially arranged on the microlens array along a perimeter corresponding to the arc segment, and wherein
- the microlens array (7) is controlled to perform a rotating movement (9) which is parallel to a straight plane, relative to at least part of the image projection system (22) and relative to the substrate (5), while synchronously the array of light sources (21) is controlled to form the time-varying images, in such way that during said rotating movement (9) of the microlens array (7) the microspots (17) describe an arc pattern on a predetermined area of the substrate (5); and
- wherein the substrate is moved in a direction substantially transverse to the arc segment.

2. A method according to claim 1, wherein the image projection system (22) projects the images onto the microlens array (7) such that radiation corresponding to the images is incident on the microlens array in a direction which is orthogonal to said straight plane.

3. A method according to any of the preceding claims, wherein the array of light sources (21) are arranged along plural circumferences having a common centre; and wherein the microlenses (8) are dimensioned to span said array in a radial direction so that the microspots are projected on a common arc segment.

4. A method according to claim 3 wherein the light sources of subsequent circumferences are positioned with a relative angle shift of radiuses connecting a respective light source and the common centre.

5. A method according to claim 1, wherein the projected arc segment is one-dimensional and wherein the substrate movement has a constant velocity.

6. An illumination system for patterning a substrate (5), wherein the illumination system (20) comprises:
- an array of light sources (21) controllable to form time-varying images,
- an image projection system (22), and
- a movable microlens array (7) comprising microlenses (8) which are arranged in two dimensions of a straight plane;
- the image projection system (22) is arranged for projecting the images onto the microlens array (7) such that individual ones of the microlenses (8) each project radiation (18) incident thereon in the form of separate corresponding concentrated microspots (17) onto the predetermined area of the substrate (5);
- the illumination system (20) further comprising a controller (24) for controlling movement (9) of said microlens array (7) and for controlling the array of light sources (21) to form the time-varying images synchronously with said movement in such way that the microspots (17) describe and pattern the predetermined area of the substrate (5) when said movement (9) is also relative to the substrate (5)
- wherein the array of light sources (21) is statically arranged along an arc segment having a radius and the microlenses (8) are circumferentially arranged on the microlens array along a perimeter corresponding to the arc segment, and wherein the microlens array (7) is rotatable parallel to said straight plane to perform said movement, and relative to at least part of the image projection system (22) and to the substrate (5), in such way that during rotation (9) of the microlens array (7) the microspots (17) describe an arc pattern on a predetermined area of the substrate (5).

7. An illumination system according to claim 6, wherein the image projection system (22) is arranged for projecting the images onto the microlens array (7) such that radiation corresponding to the images is incident on the microlens array in a direction which is substantially orthogonal to said straight plane.

8. An illumination system according to claim 6, wherein the array of light sources (21) are arranged along plural circumferences having a common centre; and wherein the microlenses (8) are dimensioned to span said array in a radial direction so that the microspots are projected on a common arc segment.

9. An illumination system according to claim 8, wherein the light sources of subsequent circumferences are positioned with a relative angle shift of radiuses connecting a respective light source and the common centre.

10. A system for patterning a substrate (5), comprising an illumination system (20) according to any of claims 6-9, a substrate holder (11) for holding the substrate (5) to be patterned, and an actuator (12) for moving the product holder (11) relative to the illumination system (20) in a direction substantially transverse to the arc segment.
